Europäisches Patentamt

European Patent Office

Office européen des brevets

(11) Publication number: **0 105 386**
**B1**

(12) EUROPEAN PATENT SPECIFICATION

(45) Date of publication of patent specification: **08.10.86**

(51) Int. Cl.⁴: **H 04 N 5/30,** H 04 N 3/15, H 01 L 27/14

(21) Application number: **83901229.1**

(22) Date of filing: **16.04.83**

(86) International application number:
**PCT/JP83/00123**

(87) International publication number:
**WO 83/03730 27.10.83 Gazette 83/25**

(54) SOLID-STATE IMAGE PICKUP ELEMENT.

(30) Priority: **17.04.82 JP 64591/82**
**24.04.82 JP 69279/82**

(43) Date of publication of application:
**18.04.84 Bulletin 84/16**

(45) Publication of the grant of the patent:
**08.10.86 Bulletin 86/41**

(84) Designated Contracting States:
**DE FR GB NL**

(56) References cited:
**FR-A-2 506 546**
**JP-A-51 032 223**
**JP-B-45 037 728**
**US-A-4 209 806**

(73) Proprietor: **SONY CORPORATION**
**7-35 Kitashinagawa 6-Chome Shinagawa-ku**
**Tokyo 141 (JP)**

(72) Inventor: **SONEDA, Mitsuo**
**Atsugi Plant, Sony Corp. 14-1 Asahi-cho 4-chome**
**Atsugi-shi Kanagawa-ken 243 (JP)**
Inventor: **MAEKAWA, Toshikazu**
**Atsugi Plant, Sony Corp. 14-1 Asahi-cho 4-chome**
**Atsugi-shi Kanagawa-ken 243 (JP)**
Inventor: **OHTSU, Koji**
**Atsugi Plant, Sony Corp. 14-1 Asahi-cho 4-chome**
**Atsugi-shi Kanagawa-ken 243 (JP)**

(74) Representative: **Cotter, Ivan John et al**
**D. YOUNG & CO. 10 Staple Inn**
**London WC1V 7RD (GB)**

## Description

This invention relates to solid state image pickup devices.

There has previously been proposed a solid state image pickup apparatus that comprises: a solid state image pickup device having an image pickup surface of prescribed pattern, such as, for example, a matrix of two-dimensionally arrayed rows and columns of image pickup picture units each comprising a photoelectric transducer and a switching element; and a scanning circuit for selectively energising the switching elements in the solid state image pickup device to deliver an image pickup signal output based on signal charges produced by the photoelectric transducers in the image pickup picture units.

In such a solid state image pickup device, each switching element comprises an insulated-gate field-effect transistor (hereinafter referred to as a "MOSFET"), and the photoelectric transducers comprise a multiplicity of photodetecting diodes provided for the respective switching elements or a thin photoelectric conversion layer disposed over the two-dimensional array of switching elements.

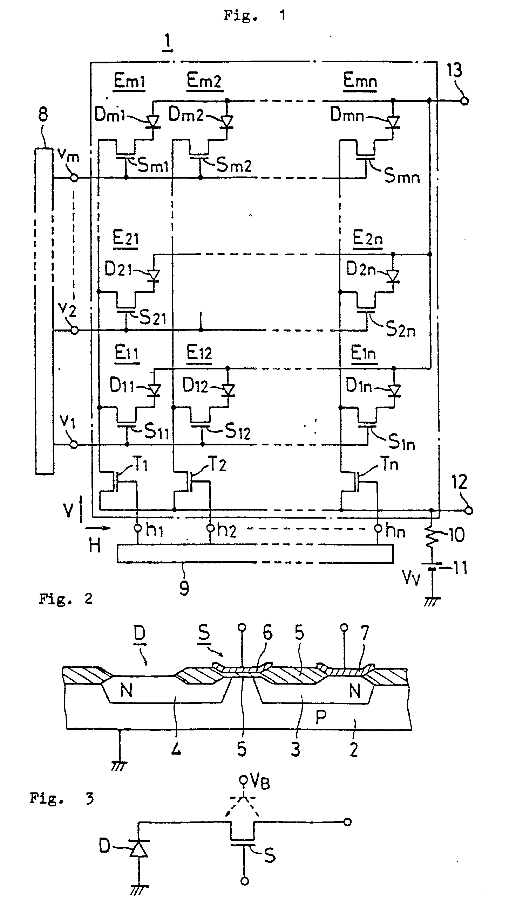

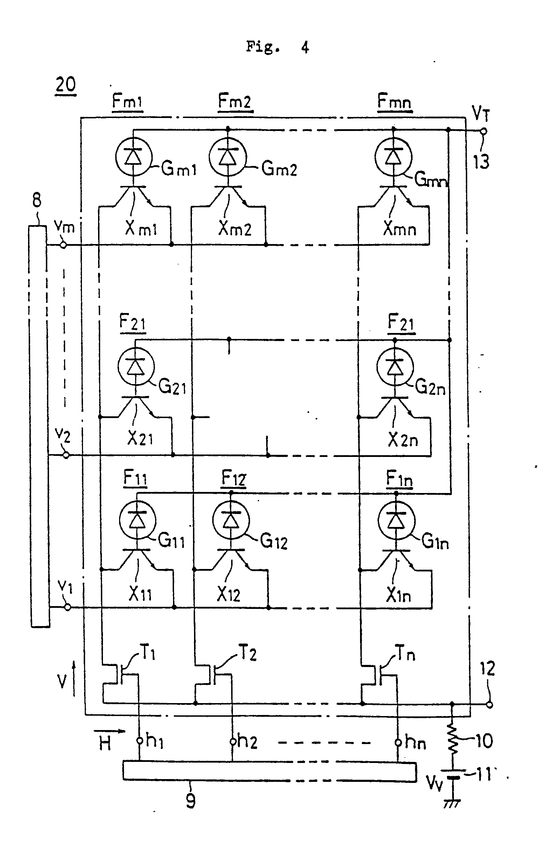

Figure 1 of the accompanying drawings shows an equivalent circuit of the previously proposed solid state image pickup device, together with a scanning circuit and an output circuit that are required for putting the device 1 into operation. The solid state image pickup device 1 comprises: MOSFET's $S_{11}$ to $S_{mn}$ serving as respective switching elements and arrayed in a matrix of horizontal rows (in the direction of an arrow H) and vertical columns (in the direction of an arrow V); and photoelectric transducers $D_{11}$ to $D_{mn}$ each connected at one end to, for example, a source of a corresponding one of the MOSFETs $S_{11}$ to $S_{mn}$. The MOSFETs $S_{11}$ to $S_{mn}$ and photoelectric transducers $D_{11}$ to $D_{mn}$ form an image pickup surface. Each combination of one of the MOSFETs $S_{11}$ to $S_{mn}$ and one of the photoelectric transducers $D_{11}$ to $D_{mn}$ forms one of a plurality of image pickup picture units $E_{11}$ to $E_{mn}$, an example of the embodied configuration of which is shown in Figures 2 and 3.

Figure 2 shows a cross-section of a portion of the solid state image pickup device 1, in which one image pickup picture unit is formed in a specific construction. In this example, N-type regions 3 and 4 are formed in a P-type semiconductor substrate 2. A gate electrode 6 is disposed between and extends partly over the regions 3 and 4 with an insulating layer 5 interposed between the gate electrode 6 and the semiconductor substrate 2 so as to form a MOSFET S (which is one of the MOSFETs $S_{11}$ to $S_{mn}$) with the region 3 serving as a drain region and the region 4 serving as a source region. The region 3 is provided with a drain electrode 7. A photodiode is constituted by a P-N junction between the semiconductor substrate 2 and the region 4 and serves as a photoelectric transducer D corresponding to one of the photoelectric

transducers $D_{11}$ to $D_{mn}$. The photodiode serves to effect photoelectric conversion of light falling on the region 4. The semiconductor substrate 2 is grounded and, accordingly, an equivalent circuit of the arrangement shown in Figure 2 with the photoelectric transducer D comprising the photodiode can be illustrated as shown in Figure 3, in which the photodiode forming the photoelectric transducer D is connected to the source of the MOSFET S and the anode of the photodiode is supplied with ground potential.

The gates of each row of the MOSFETs $S_{11}$ to $S_{mn}$ of the image pickup picture units $E_{11}$ to $E_{mn}$ are connected in common, and the groups of the gates thus connected in common are coupled to $m$ control terminals $v_1$ to $v_m$, respectively, which are supplied with vertical scanning signals from a vertical scanning circuit 8. The drains of each column of the MOSFETs $S_{11}$ to $S_{mn}$ are connected in common, and the groups of drains thus connected in common are coupled to the sources of MOSFETs $T_1$ to $T_n$, respectively, which serve as switching elements. The MOSFETs $T_1$ to $T_n$ have gates connected to $n$ control terminals $h_1$ to $h_n$, respectively, which are supplied with horizontal scanning signals from a horizontal scanning circuit 9. The drains of the MOSFETs $T_1$ to $T_n$ are connected in common through an output resistor 10 to a power supply 11 which supplies an operating voltage $V_V$. An output terminal 12 is led out from a junction between the common-connected drains of the MOSFETs $T_1$ to $T_n$ and the output resistor 10. The vertical scanning circuit 8 includes a shift register, for example, for supplying the vertical scanning signals through the $m$ control terminals $v_1$ to $v_m$ to the gates of the MOSFETs $S_{11}$ to $S_{mn}$ to energise successively the rows of MOSFETs $S_{11}$ to $S_{mn}$. The horizontal scanning circuit 9 includes a shift register, for example, for supplying the horizontal scanning signals, the horizontal scanning signals having a frequency sufficiently higher than that of the vertical scanning signals supplied from the vertical scanning circuit 8 and being supplied through the $n$ control terminals $h_1$ to $h_n$ to the gates of the MOSFETs $T_1$ to $T_n$ to energise successively the MOSFETs $T_1$ to $T_n$.

The ends of the photoelectric transducers $D_{11}$ to $D_{mn}$ remote from the sources of the MOSFETs $S_{11}$ to $S_{mn}$ are connected in common to a terminal 13 to which a predetermined voltage is applied. For example, in the case where the photoelectric transducers $D_{11}$ to $D_{mn}$ comprise a plurality of photodiodes, the terminal 13 is supplied with ground potential.

When light from an object falls on the image pickup picture units $E_{11}$ to $E_{mn}$ on the image pickup surface of the solid state image pickup device 1 constructed as described above, the photoelectric transducers $D_{11}$ to $D_{mn}$ convert light energy into electric charges (electrons) which are dependent on the quantity of incident light falling on the image picup picture units $E_{11}$ to $E_{mn}$. Each electric charge is then stored in a junction capacitor formed at each P-N junction (the P-N junction between the semiconductor substrate 2 and the region 4 in Figure 2) forming each of the photodiodes serving as the photoelectric transducers $D_{11}$ to $D_{mn}$. That is, the generated electric charges are stored in the respective sources of the MOSFETs $S_{11}$ to $S_{mn}$ as signal charges. Signals based on the signal charges stored in the sources of the MOSFETs $S_{11}$ to $S_{mn}$ are delivered to the output terminal 12 to produce an image pickup signal output when the rows of the MOSFETs $S_{11}$ to $S_{mn}$ are turned on selectively by the vertical scanning signals supplied by the vertical scanning circuit 8 and the MOSFETs $T_1$ to $T_n$ are turned on selectively by the horizontal scanning signals supplied by the horizontal scanning circuit 9.

The previously proposed solid state image pickup device of the above described construction suffers from the following disadvantages:

(i) The proportion of the area of the photoelectric transducer to the whole area in each image pickup picture unit cannot be increased and, therefore, each image pickup picture unit is of low sensitivity. Although, for obtaining higher resolution, it is desired that the area of each image pickup picture unit be reduced so that as many image pickup picture units as possible can be provided on the image pickup surface, since each image pickup picture unit requires a prescribed area for the photoelectric transducer, the entire area of each image pickup picture unit cannot be smaller than an area required to preserve such a prescribed area for the photoelectric transducer. Accordingly, it is for this reason difficult to improve the resolution.

(ii) Further, assuming that a capacitance value of the junction capacitor at the P-N junction forming each photoelectric transducer is expressed as $C_j$, the maximum quantity $Q_m$ of signal charge that can be stored in the junction capacitor is given by the equation: $Q_m = C_j \cdot (V_V - V_B)$, where $V_B$ represents a substrate voltage applied to the semiconductor substrate, which corresponds to ground potential in the foregoing example. When more electric charge is provided to be stored in the photoelectric transducer, the source potential of the MOSFET which serves as a switching element connected to the photoelectric transducer is reduced to a value lower than the potential of the semiconductor substrate and, consequently, a parasitic transistor inserted in parallel between the source and drain of the MOSFET (for example an NPN transistor having a collector formed by the drain region 3, a base formed by the semiconductor substrate 2 and an emitter formed by the source region 4 in Figure 2, and shown by broken lines in the equivalent circuit of Figure 3 as connected in parallel with the MOSFET S) is made conductive to allow the charge exceeding the quantity $C_j \cdot (V_V - V_B)$ to flow therethrough to the drain of the MOSFET. This drained charge then causes an undesired phenomenon known as blooming. The value of $(V_V - V_B)$ cannot be selected to be appreciably large because of limitations in respect of potential durability of the switching element, increment of load or burden on the scanning circuit and so on. As a result of this, the quantity $Q_m$ should be relatively small, and the dynamic range of the image pickup signal output cannot be widened.

The foregoing disadvantages make it difficult to incorporate the previously proposed solid state image pickup device described above in a high-sensitivity still-image pickup apparatus with a high-speed shutter mechanism and high-resolution image pickup apparatus.

A solid state switching device generally similar to the above-described previously proposed device is disclosed in US Patent No. US—A— 4 209 806. The device disclosed in US—A— 4 209 806 has image pickup picture units that comprise photoelectric transducers for generating signal charges dependent upon the quantity of light incident thereon and switching elements connected electrically to the photoelectric transducers so that signals based on the signal charges dependent upon the quantity of light incident on the photoelectric transducers can be derived from the image pickup picture units through the switching elements thereby to produce an image pickup signal output.

The present invention is characterised in that, in a solid state image pickup device as just defined, the image pickup picture units are operative to amplify the signal charges generated therein.

According to one form of embodiment, the switching elements of the image pickup picture units comprise bipolar transistors capable of amplifying the signal charges generated by the photoelectric transducers in response to the quantity of light falling thereon, and signals based on the amplified signal charges are delivered selectively from the image pickup picture units. According to another form of embodiment, the photoelectric transducers of the image pickup picture units are operative to generate signal charges dependent on the quantity of incident light and also to amplify the generated signal charges.

Solid state image pickup devices embodying the present invention enable high image pickup sensitivity to be realised and an image pickup signal output with an improved signal-to-noise ratio to be obtained without having to enlarge the area of the photoelectric transducers. Further, with solid state image pickup devices embodying the present invention, it is possible to prevent blooming from being caused and the dynamic range of an image pickup signal output can be widened.

The invention will now be further described, by way of illustrative and non-limiting example, with reference to the accompanying drawings, in which:

Figure 1 is an equivalent circuit diagram schematically showing a previously proposed solid state image pickup device and peripheral circuits therefor;

Figures 2 and 3 are a cross-sectional view and an equivalent circuit diagram, respectively, illustrating the configuration of a portion of the solid state image pickup device shown in Figure 1;

Figure 4 is an equivalent circuit diagram schematically showing a solid state image pickup device according to an embodiment of the present invention and peripheral circuits therefor;

Figures 5 and 6 are a cross-sectional view and an equivalent circuit diagram, respectively, illustrating the configuration of a portion of the solid state image pickup device shown in Figure 4;

Figures 7, 8, 9 and 10 are waveform diagrams and characteristic diagrams used for explaining the operation of the solid state image pickup device shown in Figure 4;

Figure 11 is an equivalent circuit diagram schematically showing a solid state image pickup device according to another embodiment of the present invention and peripheral circuits therefor;

Figures 12 and 13 are waveform diagrams used for explaining the operation of the solid state image pickup device shown in Figure 11;

Figures 14 and 15 are a cross-sectional view and an equivalent circuit diagram, respectively, illustrating the configuration of a portion of a solid state image pickup device according to a further embodiment of the present invention;

Figure 16 is an equivalent circuit diagram schematically showing the solid state image pickup device of which a portion is illustrated in Figures 14 and 15 and peripheral circuits therefor;

Figures 17 and 18 are cross-sectional views showing portions of solid state image pickup devices according to respective other embodiments of the present invention;

Figures 19 and 20 are a cross-sectional view and an equivalent circuit diagram, respectively, illustrating the configuration of a portion of a solid state image pickup device according to a further embodiment of the present invention;

Figure 21 is an equivalent circuit diagram schematically showing the solid state image pickup device of which a portion is illustrated in Figures 19 and 20 and peripheral circuits therefor; and

Figures 22 and 23 are cross-sectional views showing portions of solid state image pickup devices according to still further respective embodiments of the present invention.

Preferred embodiments of the present invention will now be described with reference to Figures 4 to 23.

Figure 4 shows an equivalent circuit of a solid state image pickup device according to one embodiment of the present invention, together with a scanning circuit and an output circuit for putting the solid state image pickup device into operation. The solid state image pickup device, which is designated at 20 in its entirety, has an image pickup surface containing image pickup picture units $F_{11}$ to $F_{mn}$ arrayed in the same manner as the image pickup picture units $E_{11}$ to $E_{mn}$ in the solid state image pickup device 1 illustrated in Figure 1. Each of the image pickup picture units $F_{11}$ to $T_{mn}$ comprises one of a plurality of photoelectric transducers $G_{11}$ to $G_{mn}$ for generating a signal charge in response to light falling thereon, and one of a plurality of NPN type bipolar transistors (hereinafter referred to simply as "transistors") $X_{11}$ to $X_{mn}$ serving as switching elements and arrayed as a matrix in rows and columns.

The transistors $X_{11}$ to $X_{mn}$ have bases connected, respectively, to the photoelectric transducers $G_{11}$ to $G_{mn}$. The emitters of the transistors $X_{11}$ to $X_{mn}$ in respective rows are connected in common to control terminals $v_1$ to $v_m$, respectively, which are supplied with vertical scanning signals by the vertical scanning circuit 8, and the collectors of the transistors $X_{11}$ to $X_{mn}$ in respective columns are connected in common to the sources of MOSFETs $T_1$ to $T_n$, respectively, which serve as switching elements.

The remaining portion is constructed in the same manner as the solid state image pickup device 1 shown in Figure 1. Elements and parts in Figure 4 corresponding to elements and parts shown in Figure 1 are designated by the same references and detailed description thereof will be omitted.

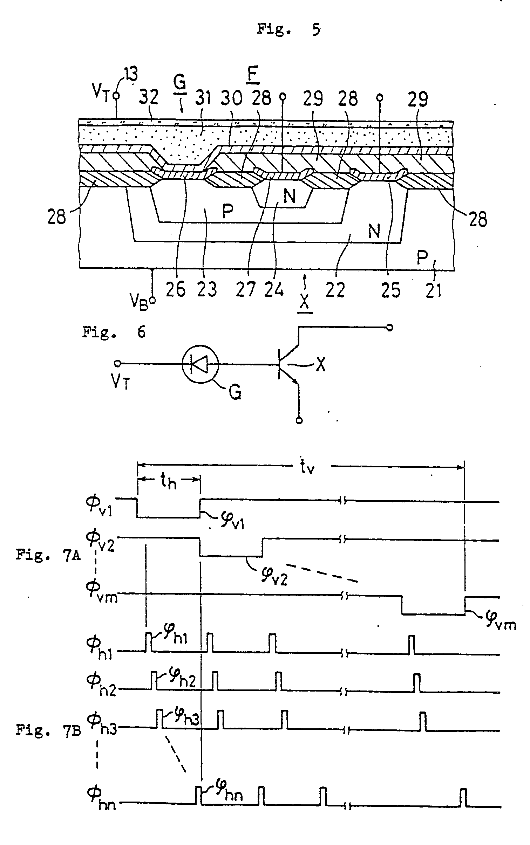

A specific structure for each of the image pickup picture units $F_{11}$ to $F_{mn}$ of the solid state image pickup device 20 of Figure 4 is illustrated in Figure 5. Figure 5 shows a cross-section of an area where one image pickup picture unit is formed in the specific structure of the image pickup device 20. An N-type region 22 is formed in a P-type semiconductor substrate 21 and a P-type region 23 is formed in the region 22. Further, an N-type region 24 is formed in the region 23. With these regions 22, 23 and 24 serving as a collector, a base and an emitter, respectively, a transistor X (which is one of the NPN-type transistors $X_{11}$ to $X_{mn}$) is formed. A collector electrode 25, a base electrode 26, and an emitter electrode 27 are disposed to contact the regions 22, 23 and 24, respectively. The portion containing the transistor X, except for the electrodes 25, 26 and 27, is covered by an insulating layer 28.

Another insulating layer 29 is disposed over the area in which the transistor X is thus formed, except for the base electrode 26. The insulating layer 29 is covered with an electrode 30 which comprises an aluminium layer, for example, and is connected to the base electrode 26. A photoelectric conversion layer 31 comprising a thin film of chalcogenides is deposited over the electrode 30, and a transparent electrode (target electrode) 32 is formed on the photoelectric conversion layer 31. The photoelectric conversion layer 31 spreading over the area where the transistor X is formed includes a portion which serves as a photoelectric transducer G, which is one of the photoelectric transducers $G_{11}$ to $G_{mn}$. Therefore, in this example, the photoelectric transducers $G_{11}$ to $G_{mn}$ are constituted by respective portions of the photoelectric conversion layer 31 extending over the image pickup surface. The photoelectric transducer G and the transistor X jointly form an image pickup picture unit F, which is one of the image pickup picture units $F_{11}$ to $F_{mn}$, to which light from an object enters through the target electrode 32.

The semiconductor substrate 21 is supplied with the substrate voltage $V_B$, and the target electrode 32 is supplied with a target voltage $V_T$ (where $V_T$ is greater than zero and less than or equal to $V_V$) from a terminal 13. The arrangement of Figure 5 can be represented by an equivalent circuit shown in Figure 6, in which one terminal of the photoelectric transducer G is connected to the base of the transistor X and the other terminal of the photoelectric transducer G is supplied with the target voltage $V_T$. The collector of the transistor X is connected to one of the MOSFETs $T_1$ to $T_n$ and the emitter thereof is connected to one of the control terminals $v_1$ to $v_m$.

When light from an object falls on the image pickup picture units $F_{11}$ to $F_{mn}$ on the image pickup surface of the solid state image pickup device 20 of the construction just described, the photo-electric transducers $G_{11}$ to $G_{mn}$ effect photoelectric conversion to produce electrons and holes as electric charges dependent on the quantity of light incident thereon. Then, signals based on the holes which are signal charges are delivered to the output terminal 12 to produce an image pickup signal output when the rows of the transistors $X_{11}$ to $X_{mn}$ are turned on selectively by the vertical scanning signals supplied by the vertical scanning circuit 8 to the emitters of the transistors $X_{11}$ to $X_{mn}$, and the MOSFETs $T_1$ to $T_n$ are turned on selectively by the horizontal scanning signals supplied by the horizontal scanning circuit 9.

To effect such vertical and horizontal scanning, the vertical scanning circuit 8 supplies the $m$ control terminals $v_1$ to $v_m$ with vertical scanning signals $\varphi_{v1}$ to $\varphi_{vm}$, respectively, as shown in Figure 7A, and the horizontal scanning circuit 9 supplies the $n$ control terminals $h_1$ to $h_n$ with horizontal scanning signals $\varphi_{h1}$ to $\varphi_{hn}$, respectively, as shown in Figure 7B. The vertical scanning signals $\varphi_{v1}$ to $\varphi_{vm}$ comprise $m$ pulses $\varphi_{v1}$ to $\varphi_{vm}$ each taking up a low level during a period $t_h$ corresponding to one horizontal period of a video signal and being generated successively during a period $t_v$ corresponding to one vertical period. The horizontal scanning signals $\varphi_{h1}$ to $\varphi_{hn}$ comprise $n$ pulses $\varphi_{h1}$ to $\varphi_{hn}$ each having a high level during a short period and being generated successively during a period corresponding to each of the pulses $\varphi_{v1}$ to $\varphi_{vm}$ of the vertical scanning signals $\varphi_{v1}$ to $\varphi_{vm}$. The transistors $X_{11}$ to $X_{mn}$ are turned on when their emitters are supplied with the pulses $\varphi_{v1}$ to $\varphi_{vm}$ of the vertical scanning signals $\varphi_{v1}$ to $\varphi_{vm}$, and the MOSFETs $T_1$ to $T_n$ are turned on when their gates are supplied with the pulses $\varphi_{h1}$ to $\varphi_{hn}$ of the horizontal scanning signals $\varphi_{h1}$ to $\varphi_{hn}$.

The pulse $\varphi_{v1}$ of the vertical scanning signal $\varphi_{v1}$ supplied by the vertical scanning circuit 8 is first applied to the emitters of the transistors $X_{11}$ to $X_{1n}$ which constitute the first row to energise the transistors $X_{11}$ to $X_{1n}$. During the period of the pulse $\varphi_{v1}$, the pulses $\varphi_{h1}$ to $\varphi_{hn}$ of the horizontal scanning signals $\varphi_{h1}$ to $\varphi_{hn}$ from the horizontal scanning circuit 9 are applied successively to the gates of the MOSFETs $T_1$ to $T_n$, respectively, to energise the MOSFETs $T_1$ to $T_n$ successively. Signal currents corresponding to the signals stored in the bases of the transistors $X_{11}$ to $X_{1n}$ are now allowed to flow through the output resistor 10, a path between the drain and source of each of the MOSFETs $T_1$ to $T_n$, and a path between the collector and emitter of each of the transistors $X_{11}$ to $X_{1n}$. As a result, an image pickup signal output produced by the image pickup picture units $F_{11}$ to $F_{1n}$ containing, respectively, the transistors $X_{11}$ to $X_{1n}$ is obtained at the output terminal 12.

Then, the pulse $\varphi_{v2}$ of the vertical scanning signal $\varphi_{v2}$ is supplied to the emitters of the transistors $X_{21}$ to $X_{2n}$ which constitute the next row, thereby to energise the transistors $X_{21}$ to $X_{2n}$, and the MOSFETs $T_1$ to $T_n$ are rendered conductive successively by the pulses $\varphi_{h1}$ to $\varphi_{hn}$ of the horizontal scanning signals $\varphi_{h1}$ to $\varphi_{hn}$. Therefore, an image pickup signal output produced by the image pickup picture units $F_{21}$ to $F_{2n}$ containing the transistor $X_{21}$ to $X_{2n}$, respectively, is obtained at the output terminal 12.

Likewise, image pickup signal outputs produced by successive rows of image pickup picture units up to the image pickup picture units $F_{m1}$ to $F_{mn}$ containing transistors $X_{m1}$ to $X_{mn}$, respectively, are delivered to the output terminal 12 successively in periods $t_v$ corresponding to one vertical period. Then, the foregoing cycle of operation is repeated.

The operation of one image pickup picture unit F on the image pickup surface of the solid state image pickup device 20 will now be described with reference to Figures 5 and 6. When light from an object falls through the target electrode 32 on a portion of the photoelectric conversion layer 31 forming the photoelectric transducer G in the image pickup picture unit F, electrons and holes are produced in the photoelectric conversion layer 31 in response to the quantity of incident light. While the electrons are trapped by the target electrode 32 supplied with the target voltage $V_T$ ($V_T$ is greater than zero), the holes are collected as signal charges at the base electrode 26 of the transistor X and stored in the base of the transistor X. When the transistor X is turned on by the pulse of low level in the vertical scanning signal applied to the emitter thereof, a current flows from the collector to the emitter thereof. The current continues to flow until the holes stored in the base of the transistor X are reunited completely with electrons flowing into the transistor X from the emitter thereof. At this time, the electric charge $Q_c$ flowing from the collector to the emitter of the transistor X can be expressed as $Q_c = h_{fex} \cdot Q_s$, where $Q_s$ represents the signal charge or the holes stored in the base of the transistor X and $h_{fex}$ represents the current amplification factor $h_{fe}$ of the transistor X. Therefore, the signal charge generated in response to the quantity of incident light is amplified by the transistor X by an amount equal to $h_{fex}$, and a signal current corresponding to the amplified signal charge flows through the transistor X. In general, the current amplification factor $h_{fe}$ of a transistor is of a considerably large value, whereby the image pickup picture unit F can perform an image pickup operation with a high degree of sensitivity.

With the solid state image pickup device 20, since the signal currents corresponding to the amplified signal charge generated by the image pickup picture units $F_{11}$ to $F_{mn}$ flow through the MOSFETs $T_1$ to $T_n$ and the output resistor 10 in the manner described above to produce the image pickup signal output at the output terminal 12, the sensitivity of the image pickup device is greatly increased and the image pickup signal output that is produced has an excellent signal-to-noise ratio.

By keeping the level of the high-level portions other than the pulses $\phi_{v1}$ to $\phi_{vm}$ of the vertical scanning signals $\phi_{v1}$ to $\phi_{vm}$ higher than the level of the target voltage $V_T$, the transistors $X_{11}$ to $X_{mn}$ (except some of them that are selected to be turned on) are prevented from being turned on undesirably, so that blooming is avoided.

In selectively energising the transistors $X_{11}$ to $X_{mn}$, an operating collector current $I_c$ of each of the transistors $X_{11}$ to $X_{mn}$ can be constant if the following relationship is satisfied:

$$d/dt(C_c) \cdot (V_E + V_{BE}) = I_c/h_{fe},$$

that is,

$$C_c \cdot d/dt(V_E) = I_c/h_{fe},$$

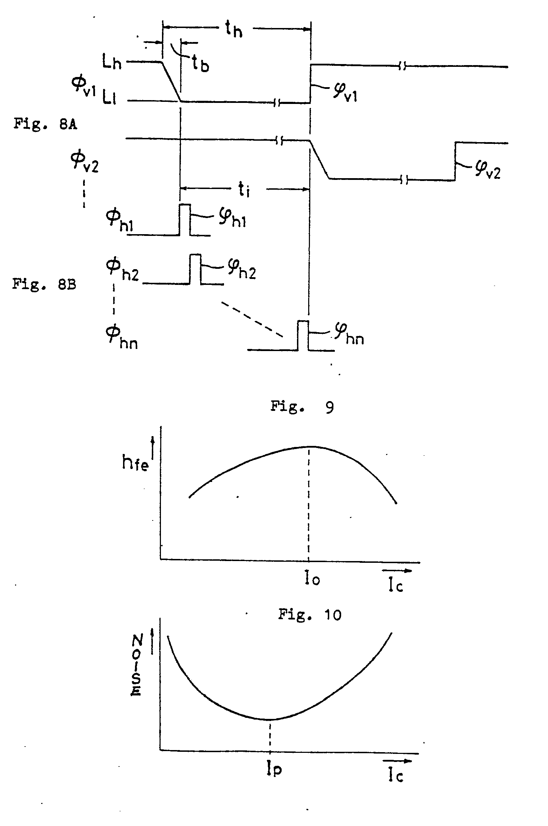

where $C_c$ represents the capacitance accompanying the base, $V_{BE}$ represents the voltage appearing between the base and emitter, and $V_E$ represents the emitter potential. If the trailing or falling edge of each of the pulses $\phi_{v1}$ to $\phi_{vm}$ of the vertical scanning signals $\phi_{v1}$ to $\phi_{vm}$ supplied to the emitters of the transistors $X_{11}$ to $X_{mn}$ has a linear slope from a level $L_h$ of the high-level portion to a level $L_1$ of the low-level portion of the vertical scanning signals $\phi_{v1}$ to $\phi_{vm}$ in a period $t_b$ corresponding to a horizontal blanking period within the period $t_h$ corresponding to the horizontal period, as shown in Figure 8A, the relationship

$$d/dt(V_E) = \Delta V_E/\Delta t = (L_h - L_1)/t_b$$

is established and the foregoing relationship can be satisfied. Accordingly, when such vertical scanning signals $\phi_{v1}$ to $\phi_{vm}$ as shown in Figure 8A are used, the operating collector current $I_c$ of each of the transistors $X_{11}$ to $X_{mn}$ is made constant regardless of the quantity of the signal charge stored in the base. In such a case, the pulses $\phi_{h1}$ to $\phi_{hn}$ of the horizontal scanning signals $\phi_{h1}$ to $\phi_{hn}$ are arranged to be generated successively in a period $t_i$ corresponding to a video period within the period $t_v$ corresponding to the horizontal period.

Since each of the transistors $X_{11}$ to $X_{mn}$ is an ordinary bipolar transistor, the operating collector current $I_c$ and the current amplification factor $h_{fe}$ thereof have a relationship as shown in Figure 9. When the operating collector current $I_c$ has a value $I_o$, the current amplification factor $h_{fe}$ takes up a maximum value. Further, the operating collector current $I_c$ and a noise level have a relationship as shown in Figure 10. The noise level is reduced to a minimum value when the operating collector current $I_c$ has a value $I_p$. Therefore, if the slope of the trailing edge of each of the pulses $\phi_{v1}$ to $\phi_{vm}$ of the vertical scanning signals $\phi_{v1}$ to $\phi_{vm}$ as illustrated in Figure 8A is selected to be

$$(L_h - L_1)/t_b = I_o/(C_c \cdot h_{fe}),$$

each of the transistors $X_{11}$ to $X_{mn}$ is used with the maximum current amplification factor during the conductive state thereof, so that the image pickup sensitivity is increased further. On the other hand, if the trailing edge slope is selected to be

$$(L_h - L_1)/t_b = I_p/(C_c \cdot h_{fe}),$$

each of the transistors $X_{11}$ to $X_{mn}$ is operated with the lowest noise level during the conductive state thereof, so that an image pickup signal output with an improved signal-to-noise ratio is obtained.

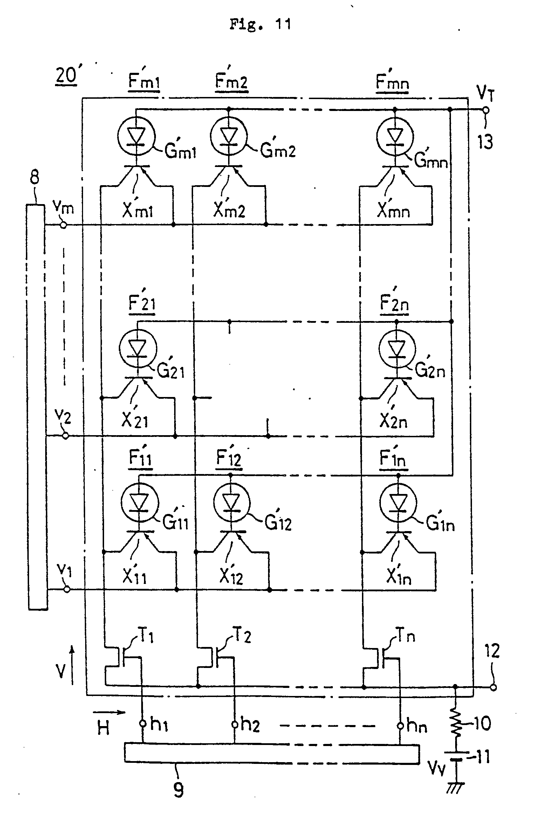

Figure 11 is an equivalent circuit diagram showing a solid state image pickup device according to another embodiment of the present invention, together with a scanning circuit and an output circuit for causing the solid state image pickup device to operate. Elements and parts in Figure 11 corresponding to elements and parts shown in Figure 4 are designated by the same references. The solid state image pickup device of this example, which is designated at 20' in its entirety, has an image pickup surface composed of image pickup picture units $F'_{11}$ to $F'_{mn}$ arrayed in the same manner as the image pickup picture units $F_{11}$ to $F_{mn}$ in the solid state image pickup device 20 illustrated in Figure 4. Each of the image pickup picture units $F'_{11}$ to $F'_{mn}$ comprises one of a plurality of photoelectric transducers $G'_{11}$ to $G'_{mn}$ which is formed by a portion of a photoelectric conversion layer comprising a thin film of amorphous silicon. A transparent target electrode disposed on the photoelectric conversion layer is supplied with a negative target voltage $V_t$ so that electrons are selected from electrons and holes generated upon incidence of light to serve as signal charges.

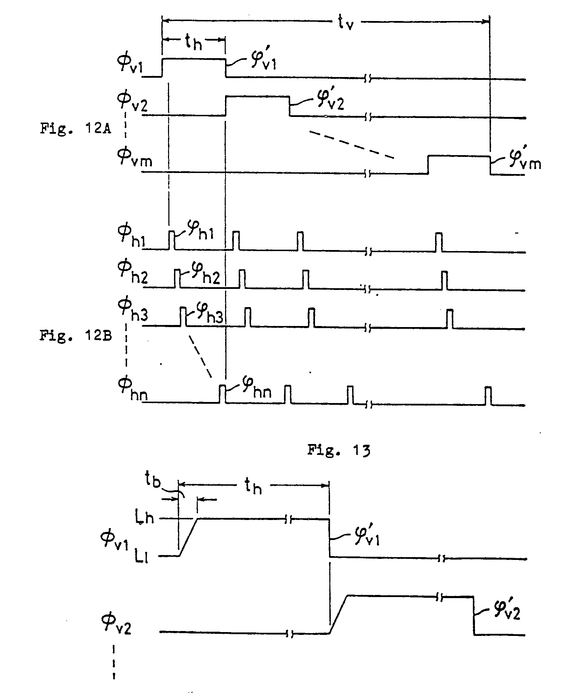

The image pickup picture units $F'_{11}$ to $F'_{mn}$ include also PNP-type transistors $X'_{11}$ to $X'_{mn}$ serving as respective switching elements. The transistors $X'_{11}$ to $X'_{mn}$ have collectors, bases and emitters connected in the same manner as those of the transistors $X_{11}$ to $X_{mn}$ in the solid state image pickup device 20. Furthermore, other portions are arranged in the same manner as the solid state image pickup device 20. In this embodiment, however, as shown in Figure 12A, vertical scanning signals $\phi_{v1}$ to $\phi_{vm}$ which are supplied to the emitters of the transistors $X'_{11}$ to $X'_{mn}$ by the vertical scanning circuit 8 comprise pulses $\varphi'_{v1}$ to $\varphi'_{vm}$ taking up a high level during the period $t_h$ corresponding to one horizontal period. The $m$ pulses $\varphi'_{v1}$ to $\varphi'_{vm}$ are generated successively in the period $t_v$ corresponding to one vertical period. As illustrated in Figure 12B, horizontal scanning signals $\phi_{h1}$ to $\phi_{hn}$ are identical to those shown in Figure 7B. The level of the pulses $\varphi'_{v1}$ to $\varphi'_{vm}$ of the vertical scanning signals $\phi_{v1}$ to $\phi_{vm}$ is selected to be higher than the operating voltage $V_V$, and the level of low level portions other than the pulses $\varphi'_{v1}$ to $\varphi'_{vm}$ of the vertical scanning signals $\phi_{v1}$ to $\phi_{vm}$ is selected to be lower than the target voltage $V_T$.

According to this embodiment, electrons generated by the photoelectric transducers $G'_{11}$ to $G'_{mn}$ in response to the quantity of light incident on the image pickup picture units $F'_{11}$ to $F'_{mn}$ are stored as signal charges in the bases of the transistors $X'_{11}$ to $X'_{mn}$. When each of the transistors $X'_{11}$ to $X'_{mn}$ is turned on, the signal charge stored in the base thereof is amplified to be multiplied by the current amplification factor $h_{fe}$, and a signal current corresponding to the amplified signal charge then flows through each of the transistors $X'_{11}$ to $X'_{mn}$. The signal currents corresponding to the signal charges generated and amplified by the image pickup picture units $F'_{11}$ to $F'_{mn}$ flow via the MOSFETs $T_1$ to $T_n$ through the output resistor 10, so that an image pickup signal output can be obtained from the output terminal 12. Thus, the solid state image pickup device of this embodiment produces an image pickup signal output having an excellent signal-to-noise ratio and free from the problem of blooming with high image pickup sensitivity, and has the same advantages as the above-described solid state image pickup device 20.

If the leading or rising edge of each of the high level pulses $\varphi'_{v1}$ to $\varphi'_{vm}$ of the vertical scanning signals $\phi_{v1}$ to $\phi_{vm}$ slopes from the low level $L_1$ to the high level $L_h$ in the period $t_b$ corresponding to the horizontal blanking period within the period $t_h$ corresponding to one horizontal period, as shown in Figure 13, and the slope of the rising edge is selected to be

$$(L_h - L_1)/t_b = I'_o/(C'_c \cdot h_{fe})$$

or

$$(L_h - L_1)/t_b = I'_p/(C'_c \cdot h_{fe}),$$

where $C'_c$ represents the capacitance at the base of each of the transistors $X'_{11}$ to $X'_{mn}$, $I'_o$ represents the operating collector current at which the current amplification factor $h_{fe}$ of each of the transistors $X'_{11}$ to $X'_{mn}$ takes up a maximum value, and $I'_p$ represents the operating collector current at which the noise level in each of the transistors $X'_{11}$ to $X'_{mn}$ takes up a minimum value, the same advantages can be obtained at those obtained in the case of the solid state image pickup device 20 when the trailing or falling edge of each of the pulses $\varphi_{v1}$ to $\varphi_{vm}$ of the scanning signals $\phi_{v1}$ to $\phi_{vm}$ is inclined at a particular scope.

In the solid state image pickup devices 20 and 20' shown in Figures 4 and 11, respectively, the lines connecting the emitters of the horizontal rows of the transistors $X_{11}$ to $X_{mn}$ or $X'_{11}$ to $X'_{mn}$ in common may be made of metal-silicide so as to provide low resistance which is advantageous for high-speed switching operation.

Further, although in each of the foregoing embodiments the image pickup surface comprises a matrix of a plurality of image pickup picture units each comprising a photoelectric transducer and a transistor, a solid state image pickup device embodying the present invention may be constituted as a line image sensor having an image pickup surface comprising a single row of image pickup picture units each comprising a photoelectric transducer and a transistor.

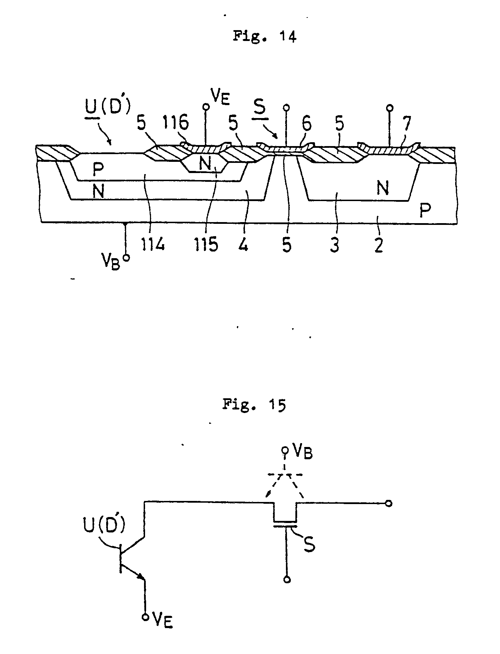

Figure 14 shows a cross-section of an image pickup picture unit of a solid state image pickup device according to a further embodiment of the present invention. Like the previously proposed arrangement of Figure 2, N-type regions 3 and 4 are provided in a P-type semiconductor substrate 2, and a MOSFET S is formed with the regions 3 and 4 serving as drain and source regions, respectively. The MOSFET S has a gate electrode 6 disposed between and extending partly over the regions 3 and 4 with an insulating layer 5 interposed between the gate electrode 6 and the semiconductor substrate 2, and a drain electrode 7.

In this embodiment, a P-type region 114 is formed in the source region 4, and an N-type region 115 is formed in the region 114. The regions 114 and 115, together with the region 4, constitute an NPN-type phototransistor U with the region 4 serving as a collector region, the region 114 as a base region and the region 115 as an emitter region. The phototransistor U constitutes one photoelectric transducer D' connected to the source of the MOSFET S. The phototransistor U has an emitter electrode 116. Light from an object falls on the base region 114 of the phototransistor U. The semiconductor substrate 2 is supplied with the substrate voltage $V_B$ and the emitter electrode 116 is supplied with the voltage $V_E$. Accordingly, the image pickup picture unit in the solid state image pickup device of this example, in which the photoelectric transducer D' comprises the phototransistor U, can be represented by way of an equivalent circuit shown in Figure 15 in which the collector of the phototransistor U forming the photoelectric transducer D' is connected to the source of the MOSFET S and the emitter of the phototransistor U is supplied with the voltage $V_E$.

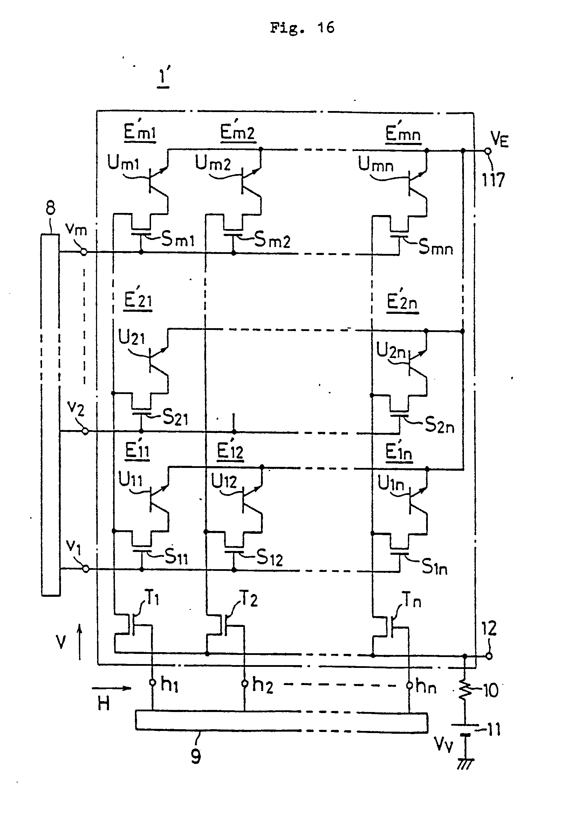

Figure 16 shows an equivalent circuit of a solid state image pickup device having an image pickup surface comprising a matrix of image pickup picture units each composing the MOSFET S and the phototransistor U as described above with reference to Figures 14 and 15, together with a scanning circuit and an output circuit for causing the solid state image pickup device to operate.

In Figure 16, elements and parts corresponding to elements and parts of Figure 1 are designated by the same references and detailed description thereof will be omitted. The solid state image pickup device of this example, which is designated 1' in its entirety, has an image pickup surface comprising a matrix of image pickup picture units $E'_{11}$ to $E'_{mn}$. Each of the image pickup picture units $E'_{11}$ to $E'_{mn}$ comprises one of a plurality of MOSFETs $S_{11}$ to $S_{mn}$ and one of a plurality of phototransistors $U_{11}$ to $U_{mn}$, which correspond to the MOSFET S and the phototransistor U shown in Figures 14 and 15. The phototransistors $U_{11}$ to $U_{mn}$ constitute photoelectric transducers. The phototransistors $U_{11}$ to $U_{mn}$ have emitters connected in common to a terminal 117 supplied with the voltage $V_E$. Other portions are arranged in the same manner as the solid state image pickup device 1 shown in Figure 1. The voltage $V_E$, the substrate voltage $V_B$ imposed on the semiconductor substrate, and the operating voltage $V_V$ are selected so that $V_V$ is greater than $V_E$ and $V_E$ is greater than or equal to $V_B$.

When light from an object falls on the image pickup picture units $E'_{11}$ to $E'_{mn}$ of the solid state image pickup device 1', each of the phototransistors $U_{11}$ to $U_{mn}$ forming the photoelectric transducers generates a signal charge dependent on the quantity of incident light and amplifies the generated signal charge. The amplified signal charge is then stored in the source of one of the MOSFETs $S_{11}$ to $S_{mn}$.

This operation will now be described with reference to Figures 14 and 15 for one of the image pickup picture units $E'_{11}$ to $E'_{mn}$. When light falls on one phototransistor U of the phototransistors $U_{11}$ to $U_{mn}$, photoelectric conversion is effected at the junction between the base and collector of the phototransistor U, that is at the P-N junction between the regions 114 and 4, to generate pairs of electrons and holes in dependence on the quantity of incident light. The generated electrons flow as signal charge into the region 4, and the generated holes flow into the region 114. As a result of this, the base potential of the phototransistor U is raised to forward-bias the junction between the base and emitter, and since the relationship that $V_V$ is greater than $V_E$ and $V_E$ is greater than or equal to $V_B$ is satisfied, a current flows from the collector to the emitter of the phototransistor U. The electric charge $Q_c$ flowing from the collector of the phototransistor U and stored in the source of the MOSFET S at this time is amplified to be $Q_c=(1+h_{fe}) \cdot Q_s$ by the amplification operation, where $h_{fe}$ is the current amplification factor of the phototransistor U and $Q_s$ is the signal charge flowing from the base to the collector of the phototransistor U. Therefore, the phototransistor U is operative to generate a signal charge that depends on the quantity of light falling thereon and also to amplify the generated signal charge by a value equal to $(1+h_{fe})$. The amplified signal charge is then stored in a stray capacitance accompanying the source of the MOSFET S.

Then, signals based on the signal charges amplified and stored in the foregoing manner in the sources of the MOSFETs $S_{11}$ to $S_{mn}$ of the image pickup picture units $E_{11}$ to $E_{mn}$ are delivered to the output terminal 12 to produce an image pickup signal output when the MOSFETs $S_{11}$ to $S_{mn}$ and $T_1$ to $T_n$ are turned on selectively in the same manner as those of the solid state image pickup device 1 illustrated in Figure 1.

With the above-described solid state image pickup device 1', since the signal charges are amplified at places where they are generated, the image pickup sensitivity is increased remarkably and an image pickup signal output with an excellent signal-to-noise ratio can be produced.

Further, when the signal charges are stored, the collector potential of each of the phototransistors $U_{11}$ to $U_{mn}$, that is the source potential of each of the MOSFETs $S_{11}$ to $S_{mn}$, is not reduced to be lower than the potential $V_E$ based on the voltage $V_E$ supplied thereto and the relationship that $V_V$ is greater than $V_E$ and $V_E$ is greater than or equal to $V_B$ is satisfied as aforesaid. Accordingly, a parasitic transistor inserted in parallel between the source and drain of each of the MOSFETs $S_{11}$ to $S_{mn}$ (for example an NPN-type transistor having a collector formed by the drain region 3, a base formed by the semiconductor substrate 2 and an emitter formed by the source region 4, and shown by broken lines in the equivalent circuit of Figure 15 as being connected in parallel with the MOSFET S can never be turned on. Therefore, no signal charge flows from the sources to the drains of the MOSFETs $S_{11}$ to $S_{mn}$ through the parasitic transistors, and blooming can be avoided.

If the stray capacitance accompanying the source of each of the MOSFETs $S_{11}$ to $S_{mn}$ is represented by $C_c$, the maximum quantity $Q'_m$ of signal charge stored in the stray capacitance $C_c$ can be expressed by the equation:

$$Q'_m = C_c \cdot (V_V - V_E).$$

The stray capacitance $C_c$ is extremely large because it is the parallel-connected sum of the capacitance between the collector and base of each of phototransistors $U_{11}$ to $U_{mn}$ (the capacitance between the regions 4 and 144) and the capacitance between the source of each of the MOSFETs $S_{11}$ to $S_{mn}$ and the semiconductor substrate (the capacitance between the region 4 and the semiconductor substrate 2). Consequently, the maximum quantity $Q'_m$ can be of a large value and the dynamic range of the image pickup signal output can be greatly widened.

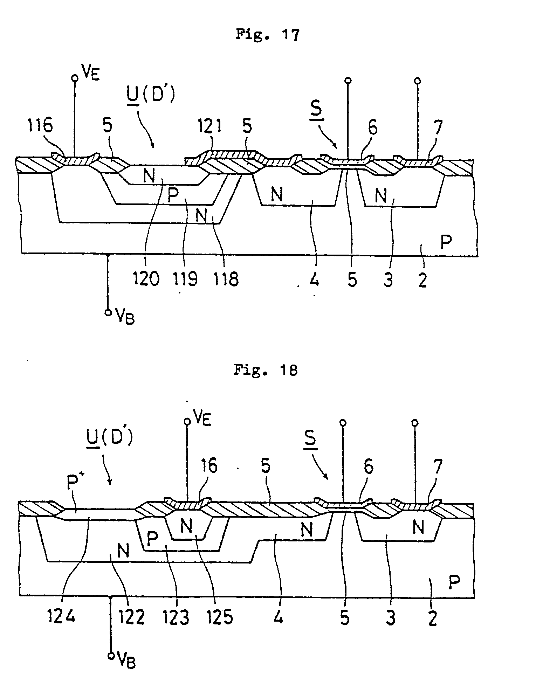

Figures 17 and 18 show cross-sectional views of image pickup picture units of solid state image pickup devices according to other embodiments of the present invention.

In the embodiment shown in Figure 17, a MOSFET S serving as a switching element is of the same configuration as illustrated in Figure 14.

However, a phototransistor U forming a photoelectric transducer D' is arranged to have an emitter formed by an N-type region 118 formed independently in a semiconductor substrate 2, a base formed by a P-type region 119 formed in the region 118, and a collector formed by a N-type thin region 120 formed in the region 119. The collector region 120 and a region 4 serving as a source region of the MOSFET S are connected by an electrode 121 with an insulating layer 5 interposed therebetween. An emitter electrode 116 is disposed on the emitter region 118.

Light from an object falls on the collector region 120 of the phototransistor U. The region 120 is thin, and the P-N junction between the base and collector for effecting photoelectric conversion, that is the P-N junction between the regions 119 and 120, is located in a shallow position below the surface of the device. Accordingly, the sensitivity to blue light is particularly improved.

In the embodiment of Figure 18, a MOSFET S serving as a switching element is also of the same configuration as illustrated in Figure 14, but a phototransistor U forming a photoelectric transducer D' has a different configuration. An N-type region 122 is formed to be continuous to a source region 4 of the MOSFET S, and a P-type region 123 is embedded in the region 122. A $P^+$-type thin region 124 is connected to the P-type region 123 and exposed on the surface. An N-type region 125 is formed in the region 123 in such a manner that the thickness of a portion of the region 123, which is sandwiched between the regions 125 and 122, is reduced. The phototransistor U thus formed has a collector formed by the region 122, a base formed by the regions 123 and 124, and an emitter formed by the region 125. An insulating layer 5 is deposited on the surface, except for the regions 124 and 125, and an emitter electrode 126 is disposed on the region 125.

Light from an object falls on the base region 124. Since the region 120 is thin, the P-N junction between the base and collector for effecting photoelectric conversion, that is the P-N junction between the regions 124 and 122, is located in a shallow position below the surface of the device in the same manner as in the arrangement of Figure 17. Accordingly, the sensitivity to blue light is particularly improved.

Because the region 124 is of $P^+$-type, the junction capacitance between the regions 122 and 124 is large. Therefore, the stray capacitance accompanying the source of the MOSFET S where signal charge is stored is large, so that the maximum quantity of signal charge stored therein is increased with the result that the dynamic range of an image pickup signal output can be widened. Further, due to the reduced thickness of the region 123 between the regions 122 and 125, the base of the phototransistor U has a reduced width, and therefore the phototransistor U acts as a vertical NPN-type transistor having a large current amplification factor $h_{fe}$ for performing effective amplification of generated signal charge.

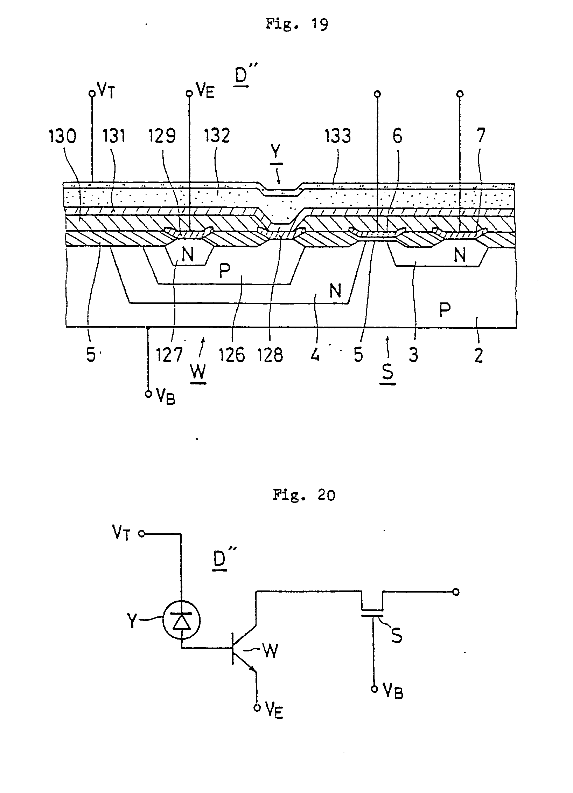

Figure 19 illustrates, in cross-section, a portion of a solid state image pickup device according to a further embodiment of the invention in which an image pickup picture unit is formed. In this emodiment, a MOSFET S serving as a switching element is of the same configuration as shown in Figure 14, and a P-type region 126 is formed in a source region 4 of the MOSFET S with an N-type region 127 formed therein. The regions 126, 127 and 4 jointly constitute an NPN-type transistor W having a collector formed by the region 4, a base formed by the region 126, and an emitter formed by the region 127. A base electrode 128 is disposed on the region 126, and an emitter electrode 129 is disposed on the region 127.

An insulating layer 130 is deposited on the surface, except for the base electrode 128, and an electrode 131 in the form of a layer is disposed on the insulating layer 130 and connected to the emitter electrode 129. A photoelectric conversion layer 132 comprising a thin film of chalcogenides is disposed over the electrode layer 131, and a transparent electrode (target electrode) 133 is deposited on the photoelectric conversion layer 132. A portion of the photoelectric conversion layer 132 extending over both the MOSFET S and the transistor W forms a signal charge generator Y which will operate on the principle of photoelectric conversion.

With this embodiment, a photoelectric transducer D'' connected to the source of the MOSFET S functioning as a switching element comprises the signal charge generator Y formed by a portion of the photoelectric conversion layer 132 and the transistor W having its base connected to the signal charge generator Y. The transistor W serves to amplify signal charge generated by the signal charge generator Y. The semiconductor substrate 2 is supplied with the substrate voltage $V_B$, the emitter electrode 129 is supplied with the voltage $V_E$, and the target electrode 133 is supplied with the target voltage $V_T$ ($V_T$ is greater than zero). The configuration of Figure 19 is represented by an equivalent circuit of Figure 20 in which the collector of the transistor W is connected to the source of the MOSFET S, the base of the transistor W is connected to one terminal of the signal charge generator Y, the voltage $V_E$ is applied to the emitter of the transistor W, and the target voltage $V_T$ is applied to the other terminal of the signal charge generator Y.

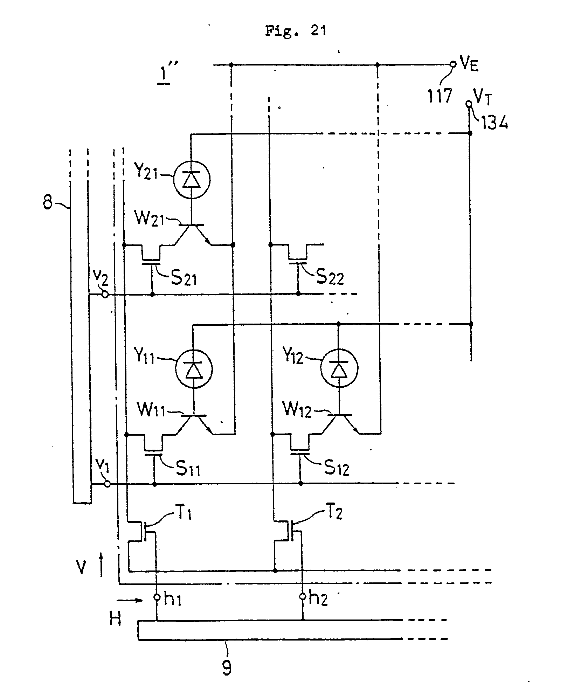

Figure 21 shows an equivalent circuit diagram of the solid state image pickup device having image pickup picture units each constituted as shown in Figures 19 and 20, and scanning circuits similar to those of Figure 16. (Only a portion of the circuit is shown, the rest being omitted from the illustration.)

In Figure 21, elements and parts corresponding to elements and parts of Figure 16 are designated by the same references. The solid state image pickup device, which is designated 1'' in its

entirety, has transistors $W_{11}$ to $W_{12}$, . . . and signal charge generators $Y_{11}$, $Y_{12}$, . . ., each corresponding to the transistor W and the signal charge generator Y, respectively, in Figures 19 and 20, instead of the phototransistors $U_{11}$ to $U_{mn}$ in the solid state image pickup device 1' shown in Figure 16. The transistors $W_{11}$, $W_{12}$, . . . have their emitters connected in common to a terminal 117 supplied with a voltage $V_E$, and the signal charge generators $Y_{11}$, $Y_{12}$, . . . have terminals connected in common to a terminal 134 supplied with a target voltage $V_T$. Other portions are arranged in the same manner as in the solid state image pickup device 1' illustrated in Figure 16. The voltages are selected to meet the relationship that $V_V$ is greater than $V_E$ and $V_E$ is greater than or equal to $V_B$, in the same manner as those of the solid state image pickup device 1'.

The operation of one of the image pickup picture units of the solid state image pickup device 1" will now be described with reference to Figures 19 and 20. When light falls through the target electrode 133 on to the portion of the photoelectric conversion layer 132 forming the signal charge generator Y, electrons and holes are generated in the photoelectric conversion layer 132. The electrons are trapped by the target electrode 133 supplied with the target voltage $V_T$, and the holes are collected as a signal charge at the base electrode 128 of the transistor W. As a result of this, the base potential of the transistor W is raised to forward-bias the junction between the base and emitter, and since the relationship that $V_V$ is greater than $V_E$ and $V_E$ is greater than or equal to $V_B$ is satisfied, a current flows from the collector to the emitter of the transistor W. The electric charge $Q'_c$ flowing from the collector to the emitter of the transistor W at this time is amplified by the transistor W to be of a value

$$Q'_c = (1 + h_{fe}) \cdot Q'_s,$$

where $h_{fe}$ represents the current amplification factor the transistor W and $Q'_s$ represents the signal charge flowing into the base of the transistor W. Therefore, the transistor W amplifies the signal charge generated in resonse to the quantity of incident light by an amount equal to $(1 + h_{fe})$. The amplified signal charge is discharged from the stray capacitance accompanying the source of the MOSFET S, and the potential of the source of the MOSFET S is reduced in proportion to the amplified signal charge. This is equivalent to the fact that the same quantity of electrons as that of the holes acting as the amplified signal charge is stored in the source of the MOSFET·S. Then, a signal based on variations in the potential of the source of the MOSFET S is delivered to produce an image pickup signal output through the MOSFET S.

The solid state image pickup device 1" of the foregoing configuration has the same effects and advantages as the solid state image pickup device 1'.

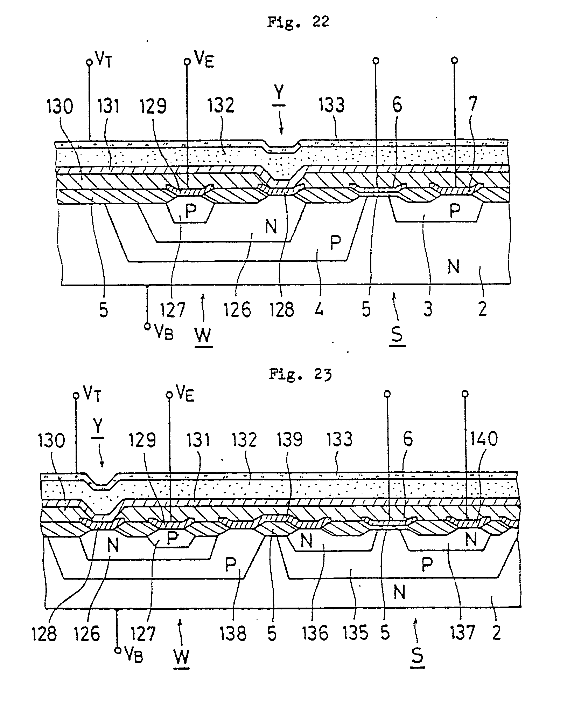

Figure 22 shows a still further embodiment which differs from the embodiments of Figures 19 and 21 in that it comprises a MOSFET S of P-channel type employing an N-type semiconductor substrate 2, and a transistor W of the PNP-type. A photoelectric conversion layer 132 comprises a thin film of amorphous silicon. The target voltage $V_T$ is arranged to be a negative voltage. Electrons produced in the photoelectric transducer 132 in response to the quantity of incident light are used as a signal charge and amplified by the transistor W.

It is desirable for a higher switching operation to have a MOSFET S of N-channel type. In the case where the MOSFET S is of N-channel type, a P-type well is formed in an N-type semiconductor substrate 2, and the MOSFET S is formed in the P-type well region. Figure 23 shows one example of such an arrangement. In Figure 23, a region 135 serves as the P-type well region, and a MOSFET S is provided which has drain and source regions 136 and 137 formed in the region 135. An independent P-type region 138 is formed in the semiconductor substrate 2 to provide a collector region of the transistor W. The drain region 136 of the MOSFET S and the collector region 138 of the transistor W are connected by an electrode 139, so that the transistor W is connected to the drain of the MOSFET S. The MOSFET S has a source electrode 140.

As described above, solid state image pickup devices embodying the present invention have an extremely high image pickup sensitivity and can produce an image pickup signal output which has an excellent signal-to-noise ratio and a widened dynamic range, and is substantially free from the problem of blooming. Accordingly, solid state image pickup devices embodying the present invention are suitable for use in forming a still image pickup apparatus with a high-speed shutter. Further, since solid state image pickup devices embodying the present invention have high-sensitivity characteristics and comprise a multiplicity of individual image pickup picture units of small area in an image pickup surface of a fixed area, the devices are suitable also for use in high-resolution image pickup apparatus.

**Claims**

1. A solid state image pickup device (20; 20'; 1'; 1") having image pickup picture units ($F_{11}$ to $F_{mn}$; $F'_{11}$ to $F'_{mn}$; $E'_{11}$ to $E'_{mn}$) that comprise photoelectric transducers ($G_{11}$ to $G_{mn}$; $G'_{11}$ to $G'_{mn}$; $U_{11}$ to $U_{mn}$; $Y_{11}$ etc. and $W_{11}$ etc.) for generating signal charges dependent upon the quantity of light incident thereon and switching elements ($X_{11}$ to $X_{mn}$; $X'_{11}$ to $S'_{mn}$; $S_{11}$ to $S_{mn}$) connected electrically to the photoelectric transducers so that signals based on the signal charges dependent upon the quantity of light incident on the photoelectric transducers can be derived from the image pickup picture units through the switching elements thereby to produce an image pickup signal output, characterised in that the image pickup picture units are operative to amplify the signal charges generated therein.

2. A solid state image pickup device (20; 20′) according to claim 1, wherein the switching elements ($X_{11}$ to $X_{mn}$; $X'_{11}$ to $X'_{mn}$) are operative to amplify the signal charges dependent upon the quantity of light incident on the photoelectric transducers ($G_{11}$ to $G_{mn}$; $G'_{11}$ to $G'_{mn}$) to deliver signals based on the amplified signal charge.

3. A solid state image pickup device (20; 20′) according to claim 2, wherein the switching elements comprise bipolar transistors ($X_{11}$ to $D_{mn}$; $X'_{11}$ to $X'_{mn}$) having bases connected to the photoelectric transducers ($G_{11}$ to $G_{mn}$; $G'_{11}$ to $G'_{mn}$), whereby, when emitters of the bipolar transistors are supplied with control signals, the signals based on the signal charges dependent upon the quantity of light incident on the photoelectric transducers ($G_{11}$ to $G_{mn}$; $G'_{11}$ to $G'_{mn}$) and amplified by the bipolar transistors are delivered through collectors of the bipolar transistors.

4. A solid state image pickup device (1′; 1″) according to claim 1, wherein the photoelectric transducers ($U_{11}$ to $U_{mn}$; $Y_{11}$ etc., and $W_{11}$ etc.) are operative to generate the signal charges dependent upon the quantity of light incident thereon and to amplify the generated signal charges and the switching elements ($S_{11}$ to $S_{mn}$) are operative to deliver the signals based on the amplified signal charges from the photoelectric transducers.

5. A solid state image pickup device (1′) according to claim 4, wherein the photoelectric transducers comprise phototransistors ($U_{11}$ to $U_{mn}$) having output terminals connected to the switching elements ($S_{11}$ to $S_{mn}$).

6. A solid state image pickup device (1″) according to claim 4, wherein the photoelectric transducers comprise signal charge generators ($Y_{11}$ etc.) and amplifying transistors ($W_{11}$ etc.) having bases connected to the signal charge generators and output terminals connected to the switching elements ($S_{11}$ to $S_{mn}$).

## Patentansprüche

1. Halbleiterbildaufzeichnungseinrichtung (20; 20′; 1′; 1″), die Bildaufzeichnungseinheiten ($F_{11}$ bis $F_{mn}$; $F'_{11}$ bis $F'_{mn}$; $E'_{11}$ bis $E'_{mn}$) hat, welche aus photoelektrischen Wandlern ($G_{11}$ bis $G_{mn}$; $G'_{11}$ bis $G_{mn}$; $U_{11}$ bis $U_{mn}$; $Y_{11}$ usw. u. $W_{11}$ usw.) zum Erzeugen von Signalladungen, die abhängig von der auf sie auftreffenden Lichtmenge sind, und Schaltelementen ($X_{11}$ bis $X_{mn}$; $X'_{11}$ bis $X'_{mn}$; $S_{11}$ bis $S_{mn}$) bestehen, die elektrisch mit den photoelektrischen Wandlern verbunden sind, so daß Signale, die auf den Signalladungen beruhen, aus den Bildaufzeichnungseinheiten durch die Schaltelemente gewonnen werden könne, um dadurch ein Bildaufzeichnungsausgangssignal zu erzeugen, dadurch gekennzeichnet, daß die Bildaufzeichnungseinheiten derart wirksam sind, daß sie die Signalladungen, die darin erzeugt werden, verstärken.

2. Halbleiterbildaufzeichnungseinrichtung (20; 20′) nach Anspruch 1, bei der die Schaltelemente ($X_{11}$ bis $X_{mn}$; $X'_{11}$ bis $X'_{mn}$) wirksam sind, um die Signalladungen, die abhängig von der auf die photoelektrischen Wandler ($G_{11}$ bis $G_{mn}$; $G'_{11}$ bis $G_{mn}$) auftreffenden Lichtmenge sind, zu verstärken, um Signale auszugeben, die auf der verstärkten Signalladung beruhen.

3. Halbleiterbildaufzeichnungseinrichtung (20; 20′) nach Anspruch 2, bei der die Schaltelemente aus bipolaren Transistoren ($X_{11}$ bis $X_{mn}$; $X'_{11}$ bis $X'_{mn}$) bestehen, deren Basisanschlüsse mit den photoelektrischen Wandlern ($G_{11}$ bis $G_{mn}$; $G_{11}$ bis $G'_{mn}$) verbunden sind, wodurch wenn die Emitter der bipolaren Transistoren mit Steuersignalen beaufschlagt werden, die Signale, die auf den Signalladungen beruhen, welche abhängig von der auf die photoelektrischen Wandler ($G_{11}$ bis $G_{mn}$; $G'_{11}$ bis $G'_{mn}$) auftreffenden Lichtmenge sind und durch die bipolaren Transistoren verstärkt werden, über die Kollektoren der bipolaren Transistoren ausgegeben werden.

4. Halbleiterbildaufzeichnungseinrichtung (1′; 1″) nach Anspruch 1, bei der die photoelektrischen Wandler ($U_{11}$ bis $U_{mn}$; $Y_{11}$ usw. u. $W_{11}$ usw.) wirksam sind, um die Signalladungen, die abhängig von der auf sie auftreffenden Lichtmenge sind, zu erzeugen und die erzeugten Signalladungen zu verstärken, und bei der die Schaltelemente ($S_{11}$ bis $S_{mn}$) wirksam sind, um die Signale, die auf den verstärkten Signalladungen beruhen, aus den photoelektrischen Wandlern auszugeben.

5. Halbleiterbildaufzeichnungseinrichtung (1′) nach Anspruch 4, bei der die photoelektrischen Wandler aus Phototransistoren ($U_{11}$ bis $U_{mn}$) bestehen, die Ausgangsschlüsse haben, welche mit den Schaltelementen ($S_{11}$ bis $S_{mn}$) verbunden sind.

6. Halbleiterbildaufzeichnungseinrichtung (1″) nach Anspruch 4, bei der die photoelektrischen Wandler aus Signalladungserzeugern ($Y_{11}$ usw.) und verstärkenden Transistoren ($W_{11}$ usw.) bestehen, welche Transistoren Basisanschlüsse, die mit den Signalladungserzeugern verbunden sind, und Ausgangsanschlüsse, die mit den Schaltelementen ($S_{11}$ bis $S_{mn}$) verbunden sind, haben.

## Revendications

1. Dispositif de prise de vues à semiconducteurs (20; 20′; 1′; 1″) possédant des unités d'image de prise de vues ($F_{11}$ à $F_{mn}$; $F'_{11}$ à $F'_{mn}$; $E'_{11}$ à $E'_{mn}$) qui comprennent des transducteurs photoélectriques ($G_{11}$ à $G_{mn}$; $G'_{11}$ à $G'_{mn}$; $U_{11}$ à $U_{mn}$; $Y_{11}$, etc., et $W_{11}$, etc.) servant à produire des charges de signaux qui sont fonction de la quantité de lumière tombant sur ceux-ci et des éléments de commutation ($X_{11}$ à $X_{mn}$; $X'_{11}$ à $S'_{mn}$; $S_{11}$ à $S_{mn}$) électriquement connectés aux transducteurs photoélectriques de façon que des signaux reposant sur les charges de signaux qui sont fonction de la quantité de lumière arrivant sur les transducteurs photoélectriques puissent être extraits des unités d'image de prise de vues via les éléments de commutation de manière à produire un signal de sortie de prise de vues, caractérisé en ce que les unités d'image de prise de vues ont pour fonction d'amplifier les charges de signaux qui y sont produites.

2. Dispositif de prise de vues à semiconducteurs (20; 20') selon la revendication 1, où les éléments de commutation ($X_{11}$ à $X_{mn}$; $X'_{11}$ à $X'_{mn}$) ont pour fonction d'amplifier les charges de signaux dépendant de la quantité de lumière arrivant sur les transducteurs photoélectriques ($G_{11}$ à $G_{mn}$; $G'_{11}$ à $G'_{mn}$) pour délivrer des signaux reposant sur la charge de signal amplifiée.

3. Dispositif de prise de vues à semiconducteurs (20; 20') selon la revendication 2, où les éléments de commutation comprennent des transistors bijonction ($X_{11}$ à $D_{mn}$; $X'_{11}$ à $X'_{mn}$) dont les bases sont connectées aux transducteurs photoélectriques ($G_{11}$ à $G_{mn}$; $G'_{11}$ à $G'_{mn}$), si bien que, lorsque les émetteurs des transistors bijonction reçoivent des signaux de commande, les signaux reposant sur les charges de signaux dépendant de la quantité de lumière arrivant sur les transducteurs photoélectriques ($G_{11}$ à $G_{mn}$; $G'_{11}$ à $G'_{mn}$) et amplifiées par les transistors bijonction sont délivrés via les collecteurs des transistors bijonction.

4. Dispositif de prise de vues à semiconducteurs (1', 1") selon la revendication 1, où les transducteurs photoélectriques ($U_1$ à $U_{mn}$; $Y_{11}$, etc., et $W_{11}$, etc.) ont pour fonction de produire les charges de signaux qui dépendent de la quantité de lumière arrivant sur ceux-ci et d'amplifier les charges de signaux produites, et les éléments de commutation ($S_{11}$ à $S_{mn}$) ont pour fonction de délivrer les signaux reposant sur les charges de signaux amplifiées depuis les transducteurs photoélectriques.

5. Dispositif de prise de vues à semiconducteurs (1') selon la revendication 4, où les transducteurs photoélectriques comprennent des phototransistors ($U_{11}$ à $U_{mn}$) possédant des bornes de sortie qui sont connectées aux éléments de commutation ($S_{11}$ à $S_{mn}$).

6. Dispositif de prise de vues à semiconducteurs (1") selon la revendication 4, où les transducteurs photoélectriques comprennent des générateurs de charge de signal ($Y_{11}$, etc.) et des transistors d'amplification ($W_{11}$, etc.) dont les bases sont connectées aux générateurs de charge de signal et des bornes de sortie connectées aux éléments de commutation ($S_{11}$ à $S_{mn}$).

0 105 386

Fig. 1

Fig. 2

Fig. 3

1

Fig. 4

Fig. 5

Fig. 6

Fig. 7A

Fig. 7B

Fig. 8A

Fig. 8B

Fig. 9

Fig. 10

4

Fig. 11

Fig. 12A

Fig. 12B

Fig. 13

**Fig. 14**

**Fig. 15**

Fig. 16

Fig. 17

Fig. 18

## Fig. 19

## Fig. 20

Fig. 21

Fig. 22

Fig. 23